# EUROPÄISCHE PATENTSCHRIFT

(11) **EP 1 732 375 B1**
(45) Veröffentlichungstag und Bekanntmachung des Hinweises auf die Patenterteilung: **26.08.2009**
(21) Anmeldenummer: 06010144.1
(22) Anmeldetag: 17.05.2006
(51) Int. Cl.: H05K 7/20

(54) **Gerätelüfter**
Apparatus fan
Ventilateur d'appareil

(30) Priorität: 10.06.2005 DE 202005009522 U
(43) Veröffentlichungstag der Anmeldung: 13.12.2006
(73) Patentinhaber: ebm-papst St. Georgen GmbH & Co. KG, 78112 St. Georgen (DE)
(72) Erfinder: Strohm, Rainer, 78112 St. Georgen (DE)
(74) Vertreter: Raible, Tobias

(56) Entgegenhaltungen:
- TW-B- 231 418
- US-A1- 2003 099 094

## Beschreibung

Die Erfindung betrifft einen Gerätelüfter mit einem Gehäuse, welches zum Einbau des Gerätelüfters in ein Gerät ausgebildet ist.

Elektronische Bauteile in Geräten, beispielsweise in Computern, müssen meist gekühlt werden. Hierzu werden Gerätelüfter verwendet, welche in einem Gehäuse angeordnet sind.

Die Verwendung von elektronischen Bauteilen in einer Vielzahl unterschiedlicher Geräte zwingt dazu, Gerätelüfter auch an schlecht zugänglichen Stellen zu montieren, beispielsweise in Fahrzeugen aller Art, wo der Platz oft sehr knapp ist. An solchen versteckten Stellen ist ein Austausch eines Lüfters, z.B. zur Reparatur oder zum Ersatz durch einen neuen Lüfter, häufig sehr schwierig.

Bei bestimmten Anwendungen muss der Austausch eines Gerätelüfters innerhalb einer sehr kurzen Zeit möglich sein, damit durch einen Ausfall keine Schäden an der Elektronik auftreten können. Man bezeichnet das auch als "fliegenden Wechsel". Somit ist ein Gerätelüfter wünschenswert, welcher schnell und einfach in einem Schaltschrank, Lüftereinschub oder dergleichen montiert und demontiert werden kann.

Elektronische Bauteile werden oft in einem Schaltschrank angeordnet, den man auch als Rack bezeichnet. Meist besteht die Forderung, dass ein solcher Schaltschrank so abgeschirmt sein soll, dass aus ihm nur sehr wenig elektromagnetische Strahlung austreten kann, d.h. der Schaltschrank soll "EMV-geschützt" sein. Etwaige Öffnungen, besonders an der Vorderseite eines solchen Schaltschranks, dürfen aus diesem Grund eine bestimmte Größe nicht überschreiten. Falls Lüfter verwendet werden, die leicht austauschbar sind, gilt diese Forderung auch für solche Lüfter, und diese Forderung ist mit dem Wunsch nach leichter Montage und leichter Austauschbarkeit schwierig zu vereinen.

Aus der US 2003/0 099 094 A1 kennt man einen Gerätelüfter mit einem Gehäuse, welches nach Art eines Einschubs ausgebildet ist. Dieses Gehäuse hat an einer Seite eine seitliche Wand, an der ein federnd auslenkbares Rastglied vorgesehen ist. Letzteres kann von der Vorderseite des Gehäuses aus betätigt werden, und das geschieht dadurch, dass die vordere Abdeckung des Gerätelüfters manuell verformt wird. Nachteilig ist, dass die elektromagnatische Verträglichkeit fehlt, weil besonders an der Vorderseite elektromagnetische Strahlung leicht aus dem Gerätelüfter austreten kann.

Aus der TW 231 418 B1 kennt man einen Gerätelüfter, dessen Aufbau hinsichtlich der Verrastung sehr ähnlich ist wie derjenige nach der genannten US-A. Auch hier fehlt die elektromagnetische Verträglichkeit, weil besonders an der Vorderseite elektromagnetische Strahlung leicht aus dem Gerätelüfter austreten kann.

Es ist deshalb eine Aufgabe der Erfindung, einen neuen Gerätelüfter bereit zu stellen.

Nach der Erfindung wird diese Aufgabe durch einen Gerätelüfter gemäß Anspruch 1 gelöst. Ein solcher hat ein Gehäuse, welches nach Art eines Einschubs ausgebildet ist. Das Gehäuse hat eine Vorderseite und eine Rückseite, welch letztere beim Einbau als erstes in das Gerät eingeschoben wird, und es hat zur Verrastung im Gerät mindestens ein federnd auslenkbares Rastglied, welchem ein von der Vorderseite des Gehäuses aus aktivierbares Betätigungsglied zugeordnet ist. Dabei ist das Gehäuse mit mindestens einer Mulde versehen, in welche das bzw. die zugeordneten aktivierbaren Glieder ragen, wobei die Blende dazu ausgebildet ist, ein Austreten von elektromagnetischer Strahlung aus dem Gehäuse bzw. dem Schaltschrank zu reduzieren. Somit hat das Gehäuse auch die Funktion eines Strahlenschutzkäfigs bzw. einer Abschirmung zum Schutz von umliegenden elektronischen Bauteilen vor einer aus dem Gerätelüfter oder dem Schaltschrank austretenden Strahlung.

Weitere Einzelheiten und vorteilhafte Weiterbildungen der Erfindung ergeben sich aus dem im folgenden beschriebenen und in den Zeichnungen dargestellten, in keiner Weise als Einschränkung der Erfindung zu verstehenden Ausführungsbeispielen, sowie aus den Unteransprüchen. Es zeigt:
- Fig. 1: eine perspektivische Draufsicht auf die Oberseite eines Gehäuses für einen Gerätelüfter gemäß der Erfindung, wobei eine Blende an der Vorderseite des Lüfters im unmontierten Zustand dargestellt ist,
- Fig. 2: eine perspektivische Seitenansicht des Gehäuses der Fig. 1,
- Fig. 3: eine perspektivische Rückansicht des Gehäuses der Fig. 1,
- Fig. 4: eine perspektivische Draufsicht auf die Unterseite des Lüftergehäuses der Fig. 1,
- Fig. 5: eine schematische Darstellung von zwei Rastgliedern und deren Betätigungsorganen bei einem Gehäuse gemäß einer bevorzugten Ausführungsform der Erfindung,
- Fig. 6: eine Explosionsdarstellung einer Lüfterradanordnung für einen Gerätelüfter gemäß einer bevorzugten Ausführungsform der Erfindung,
- Fig. 7: eine perspektivische Darstellung, etwa analog Fig. 2, aber gesehen aus einem anderen Blickwinkel, wobei die Betätigungsglieder in den Griffmulden 160, 170 mit Griffstücken 300 versehen sind, um die Betätigung bequemer und sinnfälliger zu machen,
- Fig. 8: ein Griffstück 300, gesehen in Richtung des Pfeiles VIII der Fig. 11,
- Fig. 9: eine Seitenansicht des Griffstücks der Fig. 8, gesehen in Richtung des Pfeiles IX der Fig. 10,
- Fig. 10: ein Griffstück 300 gemäß Fig. 8 und 9, gesehen in Richtung des Pfeiles X der Fig. 9,
- Fig. 11: ein Griffstück 300 gemäß Fig. 8 bis 10, gesehen in Richtung des Pfeiles XI der Fig. 10,
- Fig. 12: eine perspektivische Darstellung eines Griffstücks 300 vor seiner Montage,
- Fig. 13: ein Griffstück 300 beim Vorgang seiner Montage an den Teilen 146, 148 der Fig. 2, also nach Montage der Blende 180, in perspektivischer Darstellung,
- Fig. 14: ein Griffstück 300 nach seiner Montage, in perspektivischer Darstellung,
- Fig. 15: eine Darstellung des montierten Griffstücks 300, gesehen aus einem anderen Blickwinkel und in perspektivischer Darstellung,
- Fig. 16: einen Lüfter nach der Erfindung im eingebauten Zustand in einem so genannten Einschub,
- Fig. 17: einen Schnitt, gesehen längs der Linie XVII-XVII der Fig. 16, und
- Fig. 18: einen Schnitt, gesehen längs der Linie XVIII-XVIII der Fig. 16.

In der nachfolgenden Beschreibung beziehen sich die Begriffe links, rechts, oben und unten auf die jeweilige Zeichnungsfigur und können in Abhängigkeit von einer jeweils gewählten Ausrichtung (Hochformat oder Querformat) von einer Zeichnungsfigur zur nächsten variieren. Gleiche oder gleich wirkende Teile werden in den verschiedenen Figuren mit denselben Bezugszeichen bezeichnet und gewöhnlich nur einmal beschrieben.

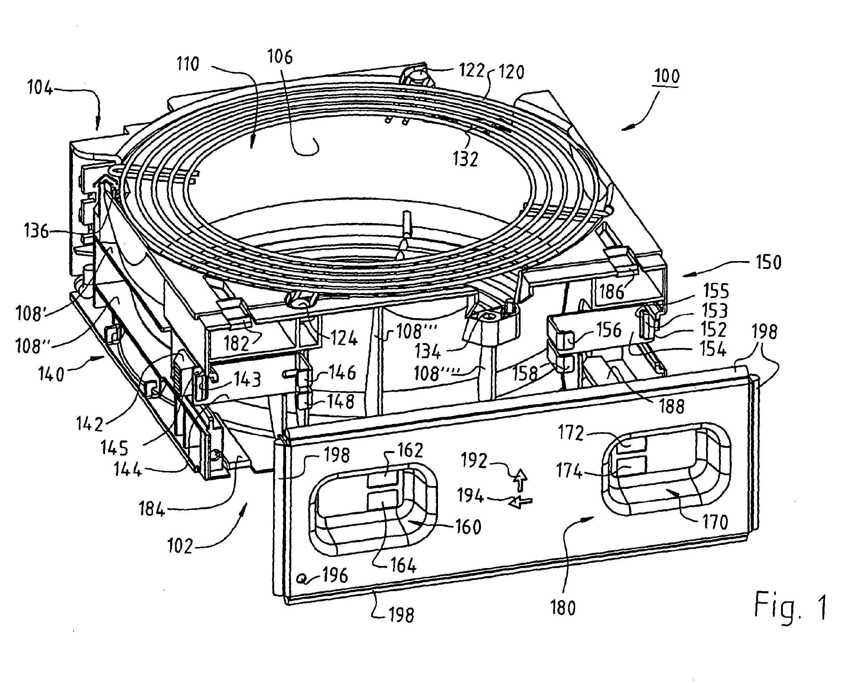

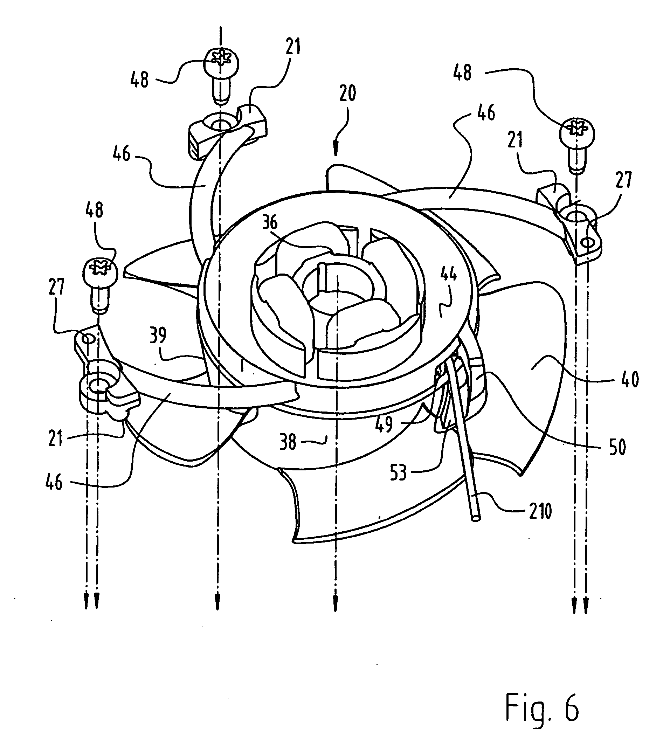

**Fig. 1** zeigt eine vergrößerte Draufsicht auf die Oberseite eines Lüftergehäuses 100 gemäß einer bevorzugten Ausführungsform der Erfindung. Dieses hat eine Ausnehmung 110 für eine Lüfterradanordnung 20 (Fig. 6), welche z.B. von einem kegelstumpfförmigen Rohr 106 begrenzt wird. Dieses wird wegen seiner Funktion auch als Venturirohr 106 bezeichnet. An seinen Außenseiten hat das Gehäuse 100 verschiedene Konstruktionselemente, beispielsweise Versteifungen bzw. Verstrebungen 108', 108", 108'" und 108"", wie sie bei der Konstruktion von Gehäusen Anwendung finden und deshalb hier nicht im Detail beschrieben werden.

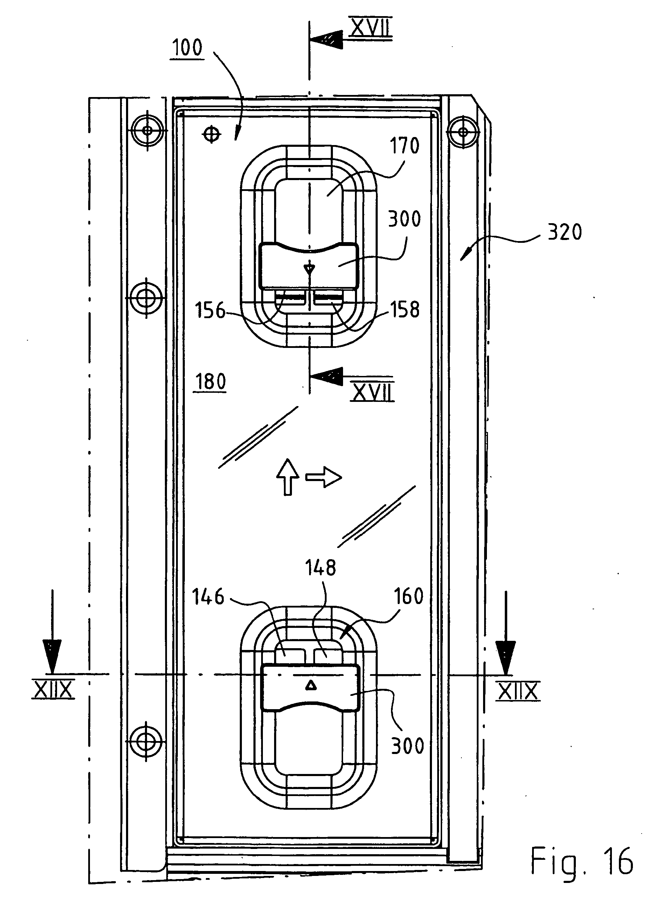

Die Umrissform des Gehäuses 100 ist in etwa rechteckförmig und vorzugsweise quadratisch, beispielsweise mit den Standardmassen 80 x 80 mm. Das Gehäuse 100 ist zur Montage in eine Lüftereinschub 320 (Fig. 16 bis 18) ausgelegt, z.B. für einen nicht dargestellten Schaltschrank. Des Weiteren können am Lüftergehäuse 100 Führungseinrichtungen (nicht dargestellt), beispielsweise Führungskanten, vorgesehen sein, welche in entsprechenden Führungsschienen im zugeordneten Gerät zur Montage/Demontage des Gehäuses 100 führbar sind. Das Gehäuse 100 hat eine Vorderseite 102, welche in Fig. 1 vorne dargestellt ist, und eine dieser gegenüberliegende Rückseite 104, welche in Fig. 1 hinten dargestellt und somit nicht sichtbar ist. Beim Einbau des Gehäuses 100 in das Gerät 320 wird die Rückseite 104 als erstes in das Gerät 320 eingeführt und dann durch Druck gegen die Vorderseite 102 bis zum Einrasten in dieses Gerät eingeschoben.

Wie aus Fig. 1 ersichtlich ist, hat das Gehäuse 100 an seiner Oberseite ein Schutzgitter 120, welches über geeignete Befestigungseinrichtungen 122, 124 wie Schrauben oder Stifte lösbar am Gehäuse 100 befestigt ist. Das Schutzgitter 120 ist vorzugsweise derart am Gehäuse 100 befestigt, dass seine Oberseite mit der Oberseite des Gehäuses 100 etwa fluchtet. Es dient zum Schutz gegen Verletzungen durch die Flügel 40 des rotierenden Lüfters (Fig. 6). Das Lüftergehäuse 100 hat Befestigungsbohrungen 132, 134, 136 zur Befestigung von Motor und Lüfterrad einer zugeordneten Lüfteranordnung 20, vgl. Fig. 6. Hierzu können Stege, welche an ihrem einen Ende am zugeordneten Motor befestigt sind, an ihren anderen, freien Enden in den Befestigungsbohrungen 132, 134, 136 zwecks Fixierung im Gehäuse 100 verschraubt werden. Alternative Befestigungsmöglichkeiten, wie beispielsweise Stifte oder Klemmen, sind ebenso geeignet.

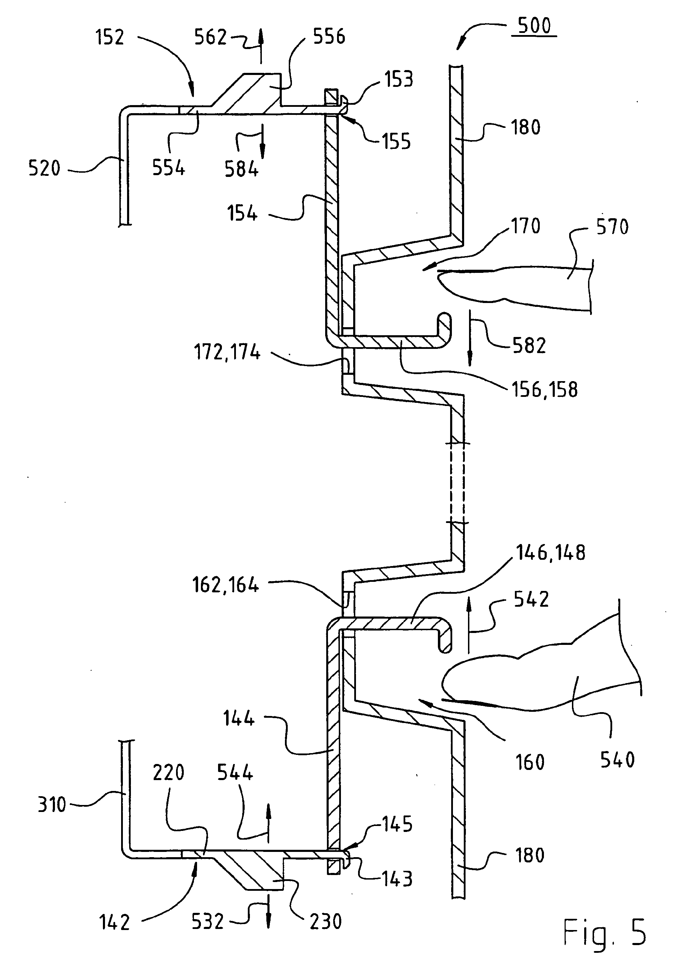

Gemäß einer bevorzugten Ausführungsform der Erfindung hat das Lüftergehäuse 100 an einer seitlichen Begrenzungsfläche 140 (Fig. 1, links) ein federnd auslenkbares Rastglied 142, welches mit einem aktivierbaren Betätigungsglied 144 verbunden ist. Hierzu wird beispielsweise ein Einhängeglied 143 des Rastgliedes 142 in eine Aussparung 145 des aktivierbaren Gliedes 144 eingehängt, wodurch eine lösbare Verbindung zwischen dem Rastglied 142 und dem aktivierbaren Glied 144 erreicht wird. Das aktivierbare Glied 144 hat an seinem rechten Ende zwei Winkelelemente 146, 148 zu seiner Aktivierung. An einer seitlichen Begrenzungsfläche 150, welche in Fig. 1 rechts dargestellt ist und der seitlichen Begrenzungsfläche 140 im Wesentlichen gegenüberliegt, hat das Gehäuse 100 ein federnd auslenkbares Rastglied 152, welches mit einem aktivierbaren Glied 154 verbunden ist, welches an seinem linken Ende zwei Winkelelemente 156, 158 zu seiner Aktivierung hat. Hierbei ist das aktivierbare Glied 154 beispielhaft über ein Einhängeglied 153, welches in eine Aussparung 155 des aktivierbaren Gliedes 154 eingehängt ist, lösbar mit dem Rastglied 152 verbunden. Die Arbeitsweise der federnd auslenkbaren Rastglieder 142, 152 und der aktivierbaren Glieder 144, 154 wird nachfolgend unter Bezugnahme auf Fig. 5 im Detail beschrieben.

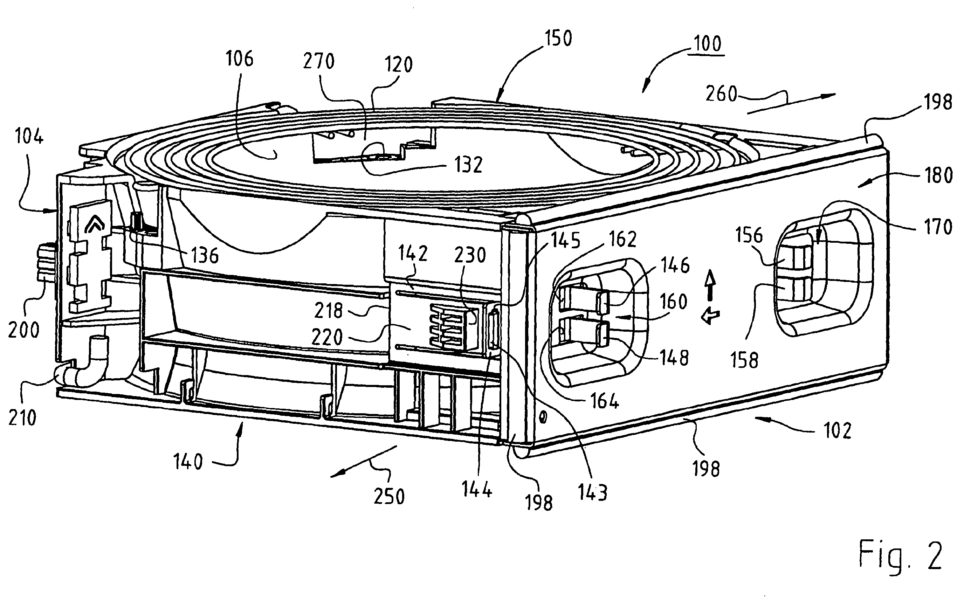

Wie aus Fig. 1 ersichtlich ist, sind die aktivierbaren Glieder 144, 154 an der Vorderseite des Gehäuses 100 angeordnet, welche von einer Blende 180 abgedeckt ist. Hierzu hat die Blende 180 gemäß einer bevorzugten Ausführungsform der Erfindung zwei Mulden 160 und 170. Die Mulde 160 ist in Fig. 1 auf der linken Seite der Blende 180 dargestellt und hat zwei Ausnehmungen 162, 164, durch welche die Winkelelemente 146, 148 des aktivierbaren Gliedes 144 bei einer Befestigung der Blende 180 am Lüftergehäuse 100 durchragen, vgl. Fig. 2. Die Mulde 170 ist in Fig. 1 auf der rechten Seite der Blende 180 dargestellt und hat zwei Ausnehmungen 172, 174, durch welche die Winkelelemente 156, 158 des aktivierbaren Gliedes 154 bei einer Befestigung der Blende 180 am Gehäuse 100 durchragen, vgl. Fig. 2.

Die Blende 180 ist dazu ausgebildet, ein Austreten von elektromagnetischer Strahlung aus dem Gehäuse 100 zu reduzieren. Hierzu ist sie aus Metall ausgebildet oder metallisiert. Sie ist über höhenvariable, elektrisch leitende, federnde Schutzelemente mit dem Gehäuse 100 elektrisch leitend verbunden. Somit hat das Gehäuse 100 auch die Funktion eines Strahlenschutzkäfigs bzw. einer Abschirmung zum Schutz von umliegenden elektronischen Bauteilen. Die Durchbrechungen 162, 164, 172, 174 der Blende 180 können so klein bemessen werden, z.B. kleiner als 12 mm, dass sie für die Wellenlänge einer möglichen Störstrahlung unkritisch sind. Zur Befestigung am Gehäuse 100 wird die Blende 180 beispielsweise, wie in Fig. 1 dargestellt, in federnde Rasthaken 182, 184, 186, 188 eingerastet. Somit kann eine lösbare Verbindung zwischen der Blende 180 und dem Gehäuse 100 erreicht werden.

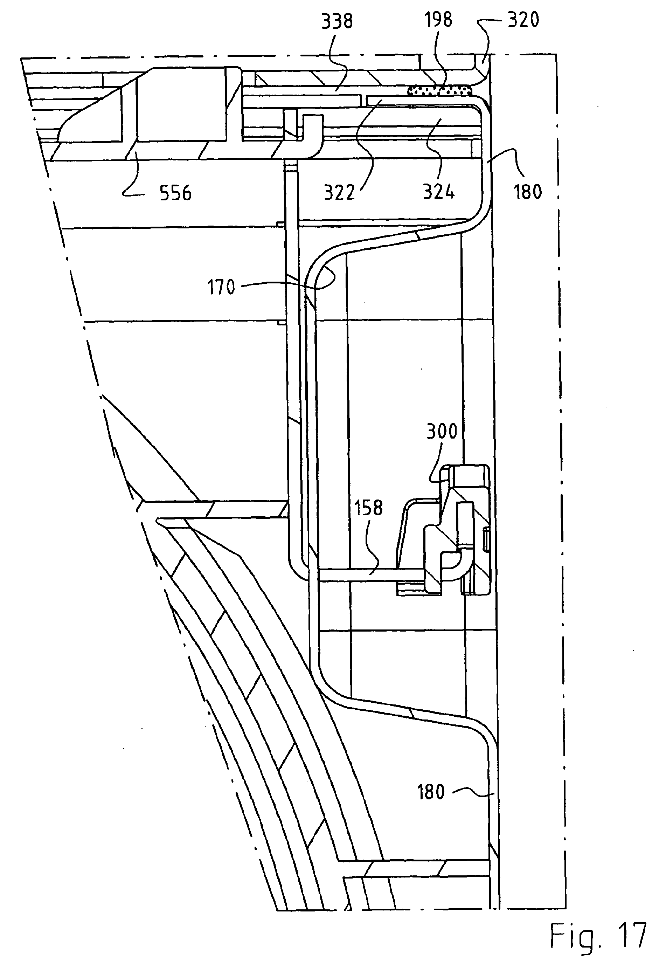

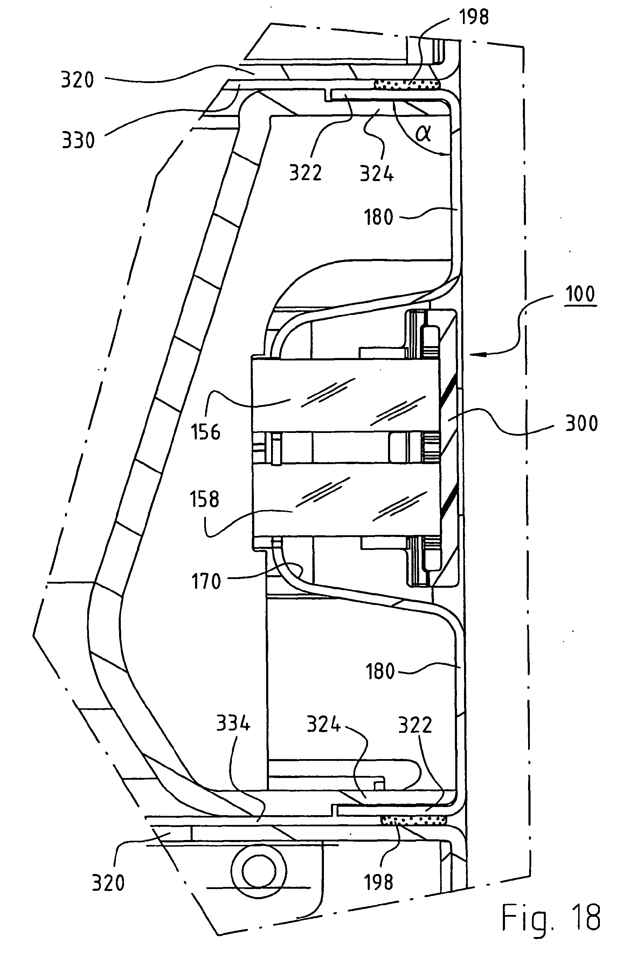

In dem in Fig. 1 dargestellten Ausführungsbeispiel sind auf der Vorderseite der Blende 180 zwei Pfeile 192, 194 abgebildet. Der Pfeil 192 zeigt die Strömungsrichtung des Gerätelüfters, d.h. die Richtung, in welcher Luft aus dem Gehäuse 100 ausgeblasen wird. Der Pfeil 194 zeigt die Drehrichtung des Lüfterrades des Gerätelüfters. In einer Aussparung 196 in der Blende 180 kann eine LED angeordnet werden, welche den Betriebszustand anzeigt. Mit 198 sind EMV-Dichtelemente bezeichnet, deren Funktion bei den Fig. 17 und 18 erläutert wird.

**Fig. 2** zeigt eine perspektivische Seitenansicht des Lüftergehäuses 100 der Fig. 1, welche insbesondere die Ausgestaltung der seitlichen Begrenzungsfläche 140 verdeutlicht. In Fig. 2 ist die Blende 180 an der Vorderseite 102 des Lüftergehäuses 100 befestigt, beispielsweise durch Einrasten der Blende 180 in den federnden Rasthaken 182, 184, 186, 188 der Fig. 1. Wie Fig. 2 zeigt, ragen hierbei die Winkelelemente 146, 148 des aktivierbaren Gliedes 144 durch die Aussparungen 162, 164 in der Mulde 160. Die Winkelelemente 156, 158 des (nicht sichtbaren) aktivierbaren Gliedes 154 ragen in die Mulde 170. Die Abmessungen der Mulden 160, 170 sind so, dass ein Eingreifen in sie, beispielsweise mit dem Daumen einer Hand in die Mulde 160 und dem Zeigefinger derselben Hand in die Mulde 170, zur Betätigung der Teile 144 und 154 möglich ist.

Fig. 2 zeigt auch die lösbare Verbindung des aktivierbaren Gliedes 144 mit dem Rastglied 142. Hierzu ist das Einhängeglied 143 des Rastgliedes 142 in die Aussparung 145 des aktivierbaren Gliedes 144 eingehängt, so dass letzteres lediglich durch seine Aufhängung am Rastglied 142 und in den Aussparungen 162, 164 der Mulde 160 an der Vorderseite 102 des Gehäuse 100 gehalten wird. Analog kann das aktivierbare Glied 154 lediglich durch seine Aufhängung am Rastglied 152 und in den Aussparungen 172, 174 der Mulde 170 an der Vorderseite 102 des Gehäuses 100 gehalten werden, vgl. Fig. 1.

Gemäß Fig. 2 hat das Rastglied 142 eine an einer Rahmenstruktur 218 des Gehäuses 100 befestigte federnde Rastzunge 220, an welcher ein Halteglied 230 ausgebildet ist. Vorzugsweise sind die federnde Rastzunge 220 und das Halteglied 230 einstückig ausgebildet. An ihrem freien Ende hat die federnde Rastzunge 220 das Einhängeglied 143, das in die Aussparung 145 des aktivierbaren Gliedes 144 eingehängt ist. Die federnde Rastzunge 220 hat eine Vorspannung, welche dazu dient, die Rastzunge 220 und somit das Halteglied 230 von dem Gehäuse 100 weg zu bewegen. Wie mit einem Pfeil 250 angedeutet ist, wird das Halteglied 230 hierbei weg von der seitlichen Begrenzungsfläche 140 des Gehäuses 100 nach links gedrückt. Aufbau und die Funktion des Rastgliedes 152 entsprechen Aufbau und Funktion des Rastgliedes 142, wobei eine entsprechende federnde Rastzunge und somit ein entsprechendes Halteglied des Rastgliedes 152 (vgl. Fig. 5) durch eine entsprechende Vorspannung von der seitlichen Begrenzungsfläche 150 des Gehäuses 100 weg bewegt werden. Wie mit einem Pfeil 260 angedeutet, wird das Halteglied des Rastgliedes 152 hierbei weg von der seitlichen Begrenzungsfläche 150 des Gehäuses 100 nach rechts gedrückt. Somit werden das Halteglied 230 des Rastgliedes 142 und das entsprechende Halteglied des Rastgliedes 152 durch die entsprechenden Vorspannungen im Wesentlichen in entgegengesetzte Richtungen von dem Gehäuse 100 weg beaufschlagt, wodurch beim Einschub des Gehäuses 100 in ein Gerät eine Verrastung des Gehäuses 100 bewirkt wird, wie unten bei Fig. 5 beschrieben wird.

Fig. 2 zeigt, dass das Schutzgitter 120 zum Einbau von Motor und Lüfterrad zunächst entfernt werden muss, damit entsprechende, am Lüfter befestigte Stege (vgl. Fig. 6) zur Befestigung der Lüftereinheit 20 mittels Verschrauben in den Befestigungsbohrungen 132, 134 (nicht sichtbar), 136 in hierfür vorgesehene Aussparungen im Venturirohr 106 eingeführt werden können. Fig. 2 zeigt eine Aussparung 270 im Venturirohr 106, welche zur Anordnung eines Steges an der Befestigungsbohrung 132 vorgesehen ist.

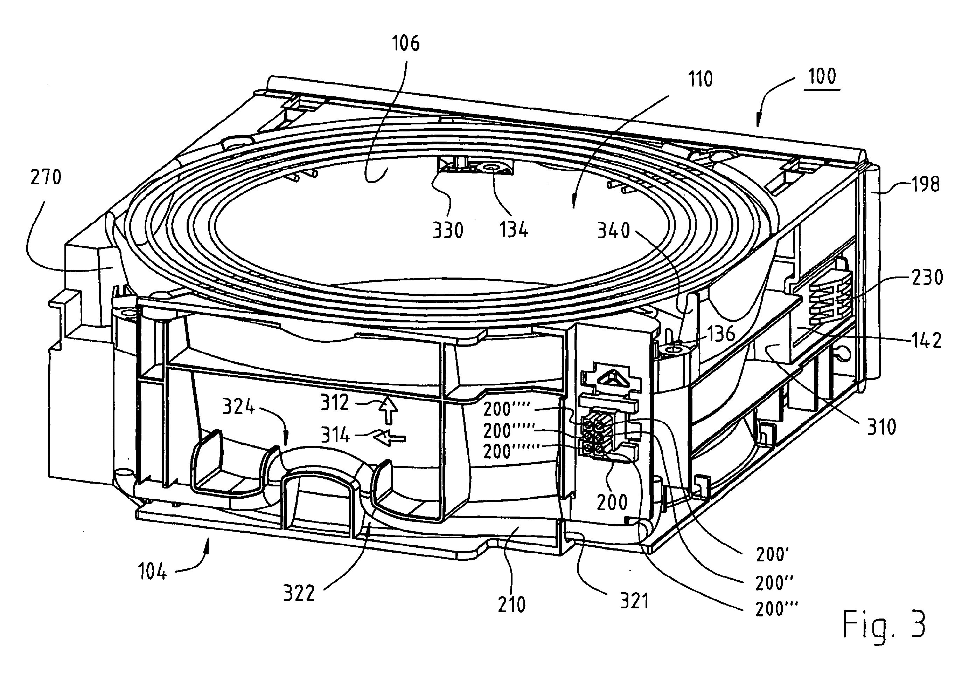

Darüber hinaus zeigt Fig. 2 eine Steckverbindung 200, welche zum Anschluss der im Gehäuse 100 angeordneten Lüftereinheit 20 dient. Der Stecker 200 ist auf der Rückseite 104 des Gehäuses 100 angeordnet und über eine Leitung 210 mit dem Motor elektrisch verbunden (vgl. Fig. 3). Da beim Einschub des Gehäuses 100 in ein Gerät 320 die Rückseite 104 als erstes eingeführt wird, wird beim Einschub des Gehäuses 100 automatisch eine elektrische Verbindung mit dem Gerät 320 bewirkt.

**Fig. 3** zeigt eine perspektivische Rückansicht des Lüftergehäuses 100, welche die Ausgestaltung der Rückseite 104 verdeutlicht.

Fig. 3 zeigt die Steckverbindung 200 als sechspoligen Stecker mit sechs Anschlusspolen 200', 200", 200"', 200"", 200""' und 200""". Ein Gerätelüfter benötigt zwei Leitungen zum Zuführen einer Betriebsspannung. Vielfach sind jedoch weitere Leitungen vorgesehen, z. B. für ein Steuer- oder ein Alarmsignal.

Im Lüftergehäuse 100 werden Leitungen von den einzelnen Anschlüssen des Steckers 200 zum Motor des Lüfters geführt und in einer Leitung 210 gebündelt, welche von der Steckverbindung 200 über eine Führungsrinne 321 und Kabelhalterklemmen 322 und 324 zum Motor geführt ist. Die Leitung 210 ist in Fig. 3 nur teilweise dargestellt.

Gemäß Fig. 3 ist im Venturirohr 106 in dessen Ausnehmung 110 eine Aussparung 330 zur Durchführung eines Steges zur Befestigung an der Befestigungsbohrung 134 vorgesehen. Zur Durchführung eines Steges dient dort eine Aussparung 340. Fig. 3 zeigt auch, dass das Rastglied 142 an einem starren Rahmenelement 310 des Gehäuses 100 befestigt ist. An der Rückseite 104 sind Pfeile 312, 314 dargestellt, welche in ihrer Funktion den Pfeilen 192 und 194 entsprechen.

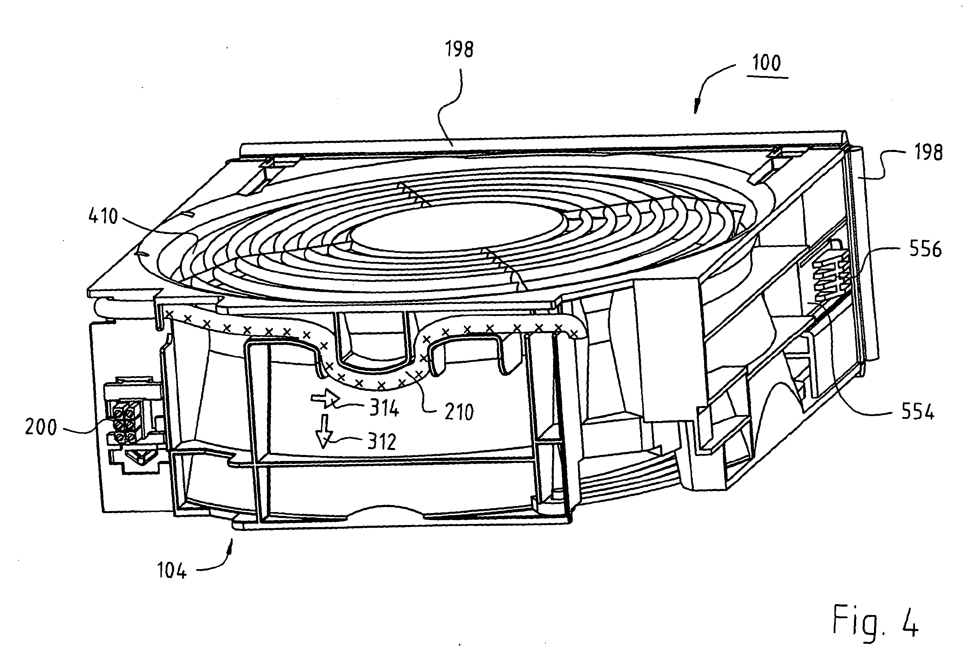

**Fig. 4** zeigt eine vergrößerte Draufsicht auf die Unterseite des Gehäuses 100. Die Draufsicht von Fig. 4 entspricht im Wesentlichen der perspektivischen Rückansicht gemäß Fig. 3, wobei das Gehäuse 100 der Fig. 3 in Fig. 4 um etwa 180° gedreht dargestellt ist.

Fig. 4 zeigt, dass das Lüftergehäuse 100 an seiner Unterseite ein Schutzgitter 410 hat, welches hier unlösbar am Gehäuse 100 befestigt ist. Die Unterseite des Gehäuses 100 und das Schutzgitter 410 können einstückig sein. Das Schutzgitter 410 ist derart an der Unterseite des Gehäuses 100 ausgebildet, dass seine Unterseite mit der Unterseite des Gehäuses 100 fluchtet.

**Fig. 5** zeigt eine Rastvorrichtung 500 für das Gehäuse 100. Sie wird von den Rastgliedern 142, 152 mit ihren zugeordneten aktivierbaren Gliedern 144, 154 im Zusammenspiel mit der Blende 180 gebildet.

Das Einhängeglied 143 des Rastgliedes 142 ist in die Aussparung 145 des Gliedes 144 eingehängt, und die Winkelelemente 146, 148 des Gliedes 144 ragen durch die Aussparungen 162, 164 in der Mulde 160. Das Einhängeglied 153 des Rastgliedes 152 ist in die Aussparung 155 des Gliedes 154 eingehängt, und die Winkelelemente 156, 158 des aktivierbaren Gliedes 154 ragen durch die Aussparungen 172, 174 in der Mulde 170 der Blende 180. Das Rastglied 142 hat eine federnde Rastzunge 220 und ein Halteglied 230 und ist am Rahmenelement 310 des Gehäuses 100 befestigt.

Durch die Vorspannung der Rastzunge 220 wird das Halteglied 230, wie in Fig. 5 dargestellt, in Richtung eines Pfeils 532 beaufschlagt. Das Rastglied 152 hat eine federnde Rastzunge 554 und ein Halteglied 556 und ist an einem Rahmenelement 520 des Gehäuses 100 befestigt, welches in Aufbau und Funktion dem Rahmenelement 310 entspricht. Durch die Vorspannung der Rastzunge 554, welche der Vorspannung der Rastzunge 220 entspricht, wird das Halteglied 556, wie in Fig. 5 dargestellt, in Richtung eines Pfeils 562 beaufschlagt. Somit werden die Halteglieder 230, 556 auf Grund der entsprechenden Vorspannungen ihrer Rastzungen 220, 554 in entgegengesetzte Richtungen beaufschlagt. Beim Einschub des Gehäuses 100 in ein Gerät 320 (Fig. 16) bewirkt die Auslenkung der Halteglieder 230, 556 dort eine automatische Verrastung des Gehäuses 100.

Gemäß einer bevorzugten Ausführungsform der Erfindung kann beispielsweise mit dem Daumen 540 einer Hand in die Mulde 160 zur Betätigung der Winkelelemente 146, 148 eingegriffen werden. Gleichzeitig kann mit dem Zeigefinger 570 derselben Hand in die Mulde 170 zur Betätigung der Winkelelemente 156, 158 eingegriffen werden. Wie Fig. 5 zeigt, sind die Abmessungen der Mulden 160, 170 derart, dass ein Eingreifen in sie mit dem Daumen 540 und dem Zeigefinger 570 zur Betätigung der aktivierbaren Glieder 144 und 154 möglich ist.

Werden die Winkelelemente 146, 148 in Richtung eines Pfeils 542 bewegt, so wird das Glied 144 in Richtung des Pfeils 542 gezogen, wodurch eine Auslenkung der Rastzunge 220 in Richtung eines Pfeils 544 bewirkt wird, und das Halteglied 230 wird entrastet. Entsprechend wird bei einer Bewegung der Winkelelemente 156, 158 in Richtung eines Pfeils 582 das Glied 154 in Richtung des Pfeils 582 gezogen, wodurch eine Auslenkung der Rastzunge 554 in Richtung eines Pfeils 562 bewirkt wird, und das Halteglied 556 wird entrastet.

Somit kann durch eine gleichzeitige Betätigung der Winkelelemente 146, 148, 156, 158 eine Lösung der Verrastung des Gehäuses 100 im zugeordneten Gerät bewirkt werden, und das Gehäuse 100 kann heraus gezogen werden. So kann bei einer Verwendung von Daumen 540 und Zeigefinger 570 einer Hand ein einhändiger Ausbau des Gehäuses 100 aus dem Gerät 320 erfolgen.

**Fig. 6** zeigt beispielhaft eine Explosionsdarstellung einer Baueinheit 20 von Antriebsmotor 36 und Lüfterrad 38 mit Lüfterflügeln 40, hier dem Lüfterrad 38 für einen Diagonallüfter. Ein solcher hat für manche Anwendungen Vorteile, weil sich eine günstigere Lüfterkennlinie ergibt. Wenn z. B. ein Filter verstopft ist und deshalb die Durchflussmenge dV/dt (Flow Rate) des Gerätelüfters 20 sinkt, steigt bei einem Diagonallüfter der erzeugte Druck Delta pf (Static Pressure) stärker an als bei einem Axiallüfter, was eine Sicherheitsreserve für den Benutzer darstellt, besonders dann, wenn ein hoher Druck bei großer Luftmenge gefordert wird. Der Stator des Motors 36 ist mit gestrichelten Linien angedeutet. Bevorzugt wird ein elektronisch kommutierter Außenläufermotor 36 verwendet.

Die Form der Lüfterflügel 40 ist an die konische Form der Innenseite des Venturirohres 106 angepasst. Das Lüfterrad 38 ist auf seiner Außenseite 39 kegelstumpfförmig ausgebildet und bildet mit dem kegelstumpfförmigen Venturirohr 106 eine Luftdurchtrittsöffnung, welche gemäß Fig. 1 bis 3 im Gehäuse 100 von dem Schutzgitter 120 aus Metall abgedeckt wird, das eine zusätzliche Abschirmung bildet.

Zur Montage des Motors 36 dient ein Befestigungsflansch 44, welcher über dünne Haltestege 46 mit dem Gehäuse 100 verbunden wird. Hierzu dienen Schrauben 48, welche in die Befestigungsbohrungen 132, 134 und 136 des Gehäuses 100 der Fig. 1 bis 4 eingeschraubt werden. Hierzu haben die Stege 46 an ihren freien Enden Verbreiterungen 21, welche in die entsprechenden Aussparungen 270, 330 und 340 des Gehäuses 100 passen (vgl. Fig. 3). Insbesondere haben zwei der Aussparungen 270, 330 und 340 einen Zentrierstift mit Klemmrippen, welcher in eine entsprechende Ausnehmung 27 der zugeordneten Verbreiterung 21 passt und so die Nabe 44 exakt im konischen Venturirohr 106 des Gehäuses 100 der Fig. 1 bis 4 zentriert.

Es wird darauf hingewiesen, dass die Verbreiterungen 21 der Baueinheit 20 in zwei 90°- und einem 180°-Winkel zueinander angeordnet sind, während die Aussparungen 270, 330 und 340 des Gehäuses 100 beispielhaft in 120°-Winkeln zueinander dargestellt sind. Dies dient zur Verdeutlichung, dass verschiedene Ausgestaltungen der Befestigungsorgane möglich sind, wobei für den Fachmann klar ersichtlich ist, dass die Anordnung der Verbreiterungen 21 und der Aussparungen 270, 330 und 340 jeweils aufeinander abzustimmen ist.

Ferner ist an der Nabe 44 ein verkürzter Steg 50 vorgesehen, dessen Funktion es ist, die flexible Anschlussleitung 210 des Motors 36 abzustützen. Wie Fig. 6 zeigt, kommt die Leitung 52 - durch eine seitliche Öffnung 49 der Nabe 44 - vom Motor 36, wo sie z. B. an einer (nicht dargestellten) Leiterplatte angelötet ist, wird dann in eine am Steg 50 vorgesehenen Führung 53 eingelegt, und dann weiter nach außen zum Lüftergehäuse 100 geführt, wo eine Zugentlastung für die Leitung 210 vorgesehen sein kann.

Der Motor 36 ist über nicht dargestellte Haltekrallen mit der Nabe 44 fest verbunden, und die Stege 46, 50 sind bevorzugt einstückig mit der Nabe 44 ausgebildet.

Wie bereits beschrieben, wird zum Einbau der Baueinheit 20 im Gehäuse 100 der Fig. 1 bis 4 das Schutzgitter 120 entfernt, und die Baueinheit 20 wird in das Lüftergehäuse 100 abgesenkt, was in Fig. 6 durch Pfeile angedeutet ist. Danach wird das Schutzgitter 120 wieder in der Oberseite des Lüftergehäuses 100 eingesetzt und befestigt.

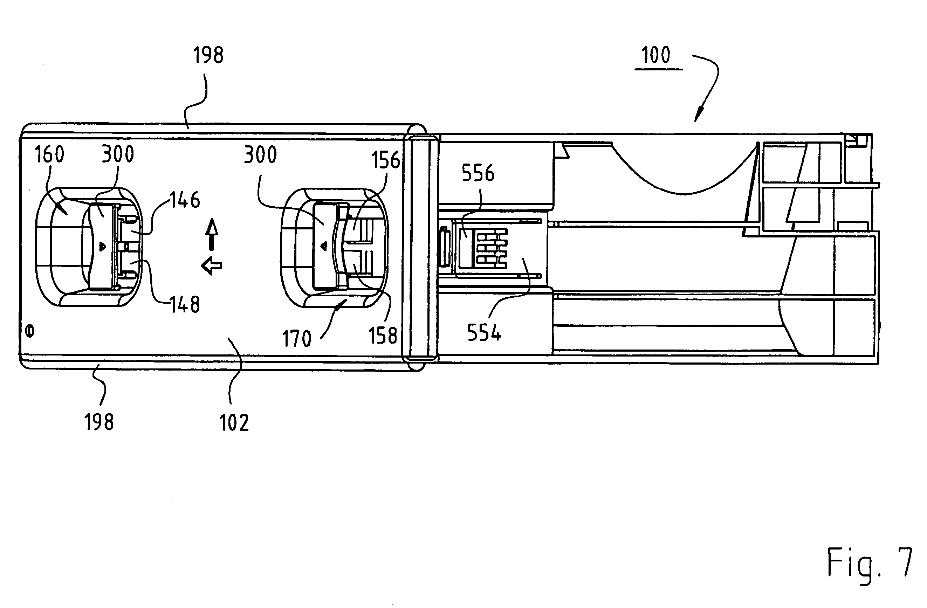

**Fig. 7** zeigt einen Einschublüfter 100, bei dem an den Teilen 146, 148 und 156, 158 jeweils ein Griffstück 300 montiert ist.

Der Grund hierfür ist, dass beim Herausziehen eines Lüfters 100 aus einem Schaltschrank oder einem Einschub auch der Stecker 200 aus dessen Gegenstück heraus gezogen werden muss, wozu eine erhebliche Kraft notwendig ist, die z.B. 30 N betragen kann. Die Griffstücke 300 dienen also auch dazu, nach dem Entrasten einen Zug auf den Einschublüfter 100 zu übertragen, um diesen aus einem Schaltschrank herauszuziehen, und sie sind entsprechend ausgebildet.

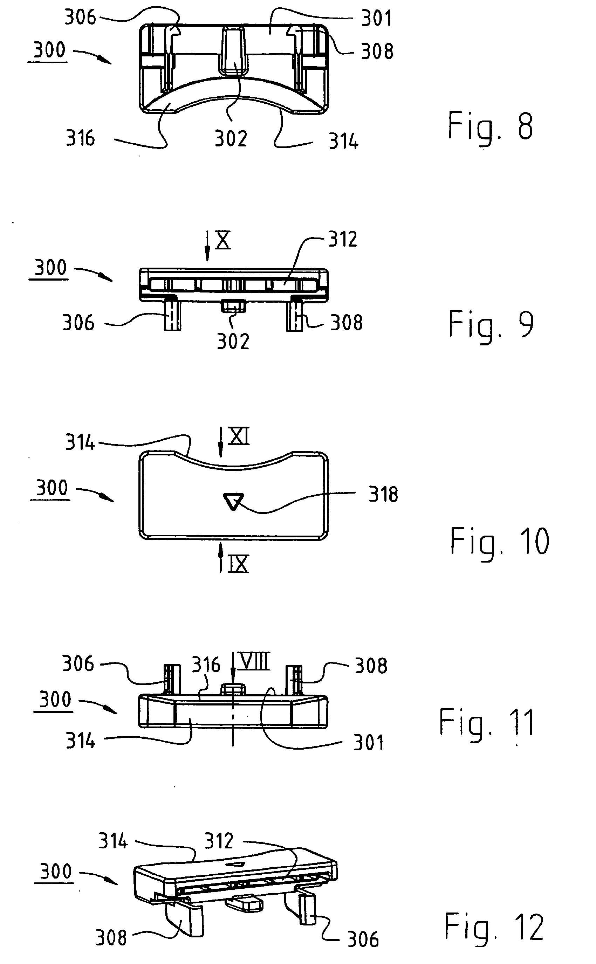

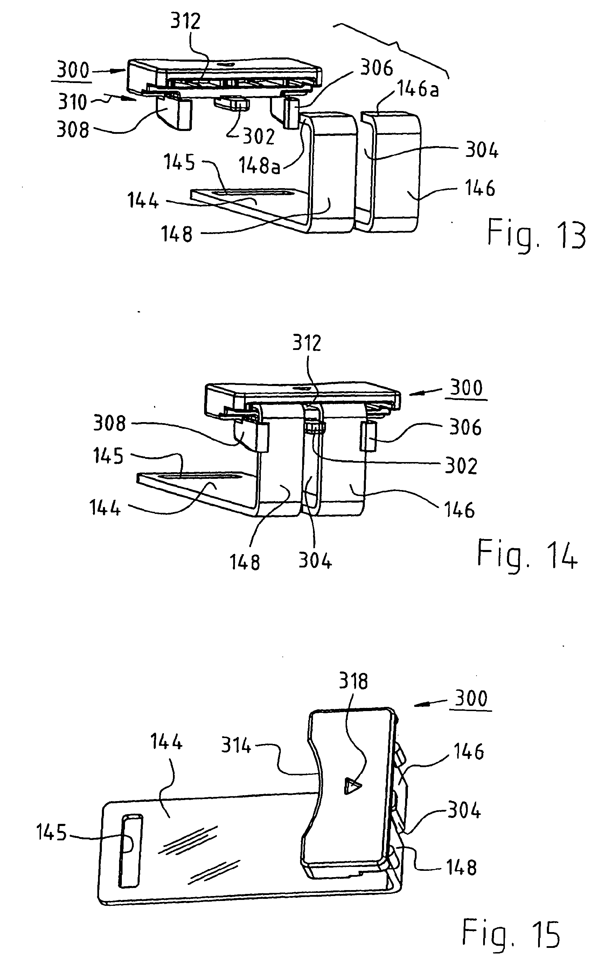

**Fig. 8** zeigt eine Draufsicht auf die Unterseite 301 eines Griffstücks 300. In der Mitte befindet sich ein Distanzstück 302, das gemäß Fig. 13 und 14 bei der Montage in den Zwischenraum 304 zwischen den Teilen 146, 148 geschoben wird, um eine Verkleinerung dieses Zwischenraums zu verhindern.

Ferner befinden sich auf der Unterseite 301 zwei federnde Rasthaken 306, 308, deren Form am besten aus Fig. 12 hervorgeht. Diese haben am freien Ende jeweils einen nach innen ragenden Haken, dessen Lage nach der Montage aus **Fig. 14** hervorgeht.

**Fig. 13** zeigt die Montage dieser Rasthaken 306, 308. Sie erfolgt dadurch, dass ein Griffstück 300 in Richtung eines Pfeiles 310 auf die abgebogenen oberen Enden 146a, 148a der Teile 146, 148 aufgeschoben wird, wobei diese oberen Enden in eine Ausnehmung 312 des Griffstücks 300 eingreifen, und die Rasthaken 306, 308 in der Weise an den Außenseiten der Teile 146, 148 einrasten, wie das Fig. 14 zeigt. Auf diese Weise kann die erforderliche Zugkraft von einem Griffstück 300 auf die oberen Enden 146a, 148a, von diesen auf die Teile 146, 148, und von diesen auf den Einschublüfter 100 übertragen werden.

Die Befestigung eines Griffstücks 300 an den Teilen 156, 158 verläuft identisch und wird deshalb nicht separat beschrieben. Sie ergibt sich aus dem symmetrischen Aufbau der Vorderseite des Einschubs 100.

Das Griffstück 300 ist dort, wo es vom Benutzer ergriffen wird, nach Art einer Mulde 314 ausgebildet und hat auf seiner Unterseite 301 im Bereich dieser Mulde 314 eine leichte Fase 316, deren Form aus Fig. 8 und 11 hervorgeht. Eine solche Form ist besonders griffgünstig. Auch hat das Griffstück 300 auf seiner Oberseite ein dreieckförmiges Symbol 318, welches anzeigt, in welche Richtung das Griffstück 300 beim Entrasten verschoben werden muss.

**Fig. 16** zeigt einen Lüfter (gemäß Fig. 7) mit einem Lüftergehäuse 100, im eingebauten Zustand in einem Einschub 320. Die Gebrauchslage ist hier senkrecht. Gleiche oder gleich wirkende Teile wie in Fig. 7 bis 15 werden mit denselben Bezugszeichen bezeichnet wie dort und gewöhnlich nicht nochmals beschrieben.

Unter einem Lüftereinschub 320 versteht man ein Teil, das ähnlich aussieht wie eine senkrecht stehende Schublade, die aus dem betreffenden Schaltschrank herausgezogen werden kann, und in der eine Mehrzahl von Lüftern angeordnet ist, gewöhnlich vier Lüfter.

In der Praxis werden solche Lüfter kontinuierlich überwacht, und wenn ein Fehler angezeigt wird, wird der betreffende Einschub 320 herausgezogen, der defekte Lüfter wird aus dem Einschub 320 heraus gezogen, durch einen neuen ersetzt, und der Einschub 320 wird wieder in den Schaltschrank zurückgeschoben, ohne dass hierfür eine Betriebsunterbrechung notwendig ist.

Man nennt das einen fliegenden Wechsel. Dieser wird durch die Griffstücke 300 wesentlich erleichtert. Man vermeidet auf diese Weise eine Betriebsunterbrechung, da der Austausch sehr rasch abläuft.

Der Einschub 320 umgibt, wie in Fig. 16 dargestellt, die Blende 180 mit geringem Abstand.

Die Blende 180 selbst ist als tiefgezogenes Teil ausgebildet, gewöhnlich aus Metall, oder aus metallisiertem Kunststoff, und ihre Ränder 322 verlaufen senkrecht zur Ebene der in Fig. 16 sichtbaren Vorderseite, also unter einem Winkel a (Fig. 18) zu dieser Vorderseite, wobei a gewöhnlich im Bereich von 90° liegt.

Diese Ränder oder Lippen 322 werden auf entsprechende Randabschnitte 324 des Gehäuses 100 aufgeschoben oder aufgepresst und verhindern so das Austreten von elektromagnetischer Strahlung aus dem Gehäuse 100. Die Befestigung ist vergleichbar mit der Befestigung des Deckels einer Blechdose, z.B. des Deckels einer Dose für Schuhwichse, der ebenfalls einen sehr dichten Verschluss bildet.

In **Fig. 18** befindet sich oben zwischen der Blende 180 des Einschublüfters und dem Lüftereinschub 320 ein Spalt 330, der durch das EMV-Dichtelement 198 zusätzlich abgedichtet ist. Letzteres besteht bevorzugt aus einem Geflecht von Metallgewebe, das auf einem Kern aus Polyurethan angeordnet ist. Naturgemäß können vielerlei Arten solcher Dichtungsbänder verwendet werden. Durch das Einschieben des Lüfters wird dieses Dichtelement 198 verformt und bewirkt so eine großflächige Verbindung.

Unten in Fig. 18 befindet sich analog ein Spalt 334, der am Rand durch das Dichtelement 198 nach außen hin verschlossen ist.

**Fig. 17** zeigt analog einen Spalt 338, der durch das EMV-Dichtelement 198 nach außen hin verschlossen ist.

Ein solches EMV-Dichtungsband 198 erstreckt sich also um die gesamte Peripherie der Blende 180 und verhindert dort das Austreten von elektromagnetischer Strahlung. Außerdem verbindet er die Blende 180 großflächig mit dem Lüftereinschub 320 und stellt so sicher, dass die Blende 180 als Teil der elektromagnetischen Abschirmung voll wirksam wird.

Auf diese Weise wird durch das Zusammenwirken des Lüftereinschubs 320, der selbst eine Abschirmung aus Metall bildet, des (nicht dargestellten) Schaltschranks, der Blende 180 mit ihren tiefgezogenen Rändern 322 und des EMV-Dichtungsbandes 198 eine sehr gute Abschirmung erreicht, die das Austreten von elektromagnetischer Strahlung aus dem Lüftereinschub 320 weitgehend verhindert und trotzdem einen sehr schnellen, fliegenden Wechsel eines defekten Lüfters ermöglicht.

Naturgemäß sind im Rahmen der vorliegenden Erfindung vielfache Abwandlungen und Modifikationen möglich.

## Patentansprüche

1. Gerätelüfter mit einem Gehäuse (100), welches nach Art eines Einschubs für ein Gerät (320) ausgebildet ist und eine Ausnehmung (110) aufweist, in der ein Lüfterrad und ein zu dessen Antrieb dienender Elektromotor angeordnet sind,
wobei im Betrieb Luft von einer Lufteintrittsseite des Gehäuses (100) zu einer Luftaustrittsseite transportiert wird,
und sich zwischen Lufteintrittsseite und Luftaustrittsseite eine Vorderseite (102) und eine Rückseite (104) des Gehäuses (100) erstrecken, welch letztere beim Einbau als erste in das Gerät (320) eingeschoben wird,
und sich zwischen Lufteintrittsseite und Luftaustrittsseite sowie zwischen Vorderseite (102) und Rückseite (104) eine erste seitliche Begrenzung (140) und eine zweite seitliche Begrenzung (150) des Gehäuses (100) erstrecken,
an der ersten seitlichen Begrenzung (140) ein erstes federnd auslenkbares Rastglied (142) vorgesehen ist,
und an der zweiten seitlichen Begrenzung (150) ein zweites federnd auslenkbares Rastglied (152) vorgesehen ist, **gekennzeichnet durch**
eine an der Vorderseite (102) des Gehäuses (100) vorgesehene Blende (180), welche dazu ausgebildet ist, ein Austreten von elektromagnetischer Strahlung aus dem Gehäuse (100) zu reduzieren, und welche mit Vertiefungen (160, 170) versehen ist,
ein erstes von der Vorderseite (102) der Blende (180) aus aktivierbares Glied (144) zur Betätigung des ersten federnd auslenkbaren Rastglieds (142), welches aktivierbare Glied (144) in eine der Vertiefungen (160) der Blende (180) ragt,
und ein zweites, von der Vorderseite der Blende (180) aus aktivierbares Glied (154) zur Betätigung des zweiten federnd auslenkbaren Rastglieds (152), welches aktivierbare Glied (154) in eine andere Vertiefung (170) der Blende (180) ragt,
wobei die aktivierbaren Glieder (144, 154; 300) so in den Vertiefungen (160, 170) der Blende (180) angeordnet sind, dass ihre gemeinsame Aktivierung mit einer einzigen Hand möglich ist.

2. Gerätelüfter nach Anspruch 1, bei welchem jedes der federnd auslenkbaren Rastglieder (142, 152) eine Vorspannung aufweist, welche dazu ausgebildet ist, das Rastglied vom Gehäuse (100) weg zu beaufschlagen, um beim Einschub des Gehäuses (100) in ein Gerät (320) eine Verrastung des Gehäuses (100) im Gerät (320) zu bewirken.

3. Gerätelüfter nach Anspruch 1 oder 2, bei welchem das Gehäuse (100) und die aktivierbaren Glieder (144, 154; 300) dazu ausgebildet sind, eine einhändige Montage und/oder Demontage des Gehäuses (100) in einem Gerät (320) zu ermöglichen.

4. Gerätelüfter nach einem der vorhergehenden Ansprüche, bei welchem die Blende (180) einen Rand (322) aufweist, der in Richtung weg von der Blende zum Gehäuse (100) ragt und im montierten Zustand dazu dient, eine im wesentlichen strahlungsdichte Verbindung mit dem Gerät (320) zu bilden.

5. Gerätelüfter nach Anspruch 4, bei welchem die Blende (180) als tiefgezogenes Teil ausgebildet ist, dessen Umrissform im Bereich der Vorderseite (102) des Gehäuses (100) eine Ebene bildet, mit welcher der Rand (322) einen Winkel (α) einschließt.

6. Gerätelüfter nach Anspruch 5, bei welchem der Winkel (α) etwa 90° beträgt.

7. Gerätelüfter nach einem der vorhergehenden Ansprüche, bei welchem mindestens ein Kontaktelement (182, 186) vorgesehen ist, welches im montierten Zustand die Blende (180) elektrisch mit dem Gehäuse (100) verbindet.

8. Gerätelüfter nach einem der vorhergehenden Ansprüche, bei welchem um die Blende (180) herum verlaufend mindestens ein EMV-Dichtelement (198) vorgesehen ist, welches dann, wenn der Lüfter nach seiner Montage in einem Gerät (320) mit letzterem einen Spalt (330, 334, 338) bildet, diesen Spalt abdichtet und das Austreten von elektromagnetischer Strahlung aus diesem Spalt reduziert.

9. Gerätelüfter nach Anspruch 8, bei welchem das EMV-Dichtelement (198) ein Geflecht von Metallgewebe aufweist.

10. Gerätelüfter nach einem der vorhergehenden Ansprüche, bei welchem die Blende (180) aus Metall ausgebildet ist.

11. Gerätelüfter nach einem der vorhergehenden Ansprüche, bei welchem die Blende (180) aus metallisiertem Kunststoff ausgebildet ist.

12. Gerätelüfter nach einem der vorhergehenden Ansprüche, bei welchem das Gehäuse (100) mindestens ein Befestigungsglied (182, 184, 186, 188) aufweist, welches dazu ausgebildet ist, die Blende (180) an dem Gehäuse (100) zu befestigen.

13. Gerätelüfter nach einem der vorhergehende Ansprüche, bei welchem das erste Rastglied (142) eine erste Vorspannung aufweist, welche dazu ausgebildet ist, dieses Rastglied vom Gehäuse (100) weg zu bewegen,
und das zweite Rastglied (152) eine zweite Vorspannung aufweist, welche dazu ausgebildet ist, dieses Rastglied vom Gehäuse (100) weg zu bewegen,
wobei erste und zweite Vorspannung im Wesentlichen in entgegengesetzte Richtungen (250, 260) wirken, um beim Einschub des Gehäuses (100) in ein Gerät (320) eine Verrastung durch die beiden Rastglieder zu bewirken.

14. Gerätelüfter nach einem der vorhergehenden Ansprüche, bei welchem das erste und das zweite aktivierbare Glied (144, 154) dazu ausgebildet sind, bei ihrer Aktivierung das erste und das zweite Rastglied (142, 152) aus dessen verrastetem Zustand in Richtung des Gehäuses (100) zu bewegen, um eine Lösung der Verrastung zu bewirken.

15. Gerätelüfter nach einem der vorhergehenden Ansprüche, bei welchem an der Rückseite (104) des Gehäuses (100) eine Steckeranordnung (200) zum elektrischen Anschluss vorgesehen ist.

16. Gerätelüfter nach Anspruch 15, bei welchem die Steckeranordnung (200) dazu ausgebildet ist, beim Einschub des Gehäuses (100) in ein Gerät (320) automatisch eine elektrische Verbindung zwischen dem Gerätelüfter und dem Gerät (320) herzustellen.

17. Gerätelüfter nach einem der vorhergehenden Ansprüche, welcher als Diagonallüfter ausgebildet ist.

## Claims

1. Appliance fan having a housing (100), which is designed in the style of a withdrawable unit for an appliance (320) and has a recess (110), in which a fan impeller and an electric motor used to drive the fan impeller are disposed,
wherein during operation air is conveyed from an air inlet side of the housing (100) to an air outlet side, and extending between air inlet side and air outlet side are a front (102) and a rear (104) of the housing (100), the rear during installation being inserted first into the appliance (320),
and extending between air inlet side and air outlet side as well as between front (102) and rear (104) are a first lateral boundary (140) and a second lateral boundary (150) of the housing (100),
a first resiliently deflectable detent member (142) is provided on the first lateral boundary (140),
and a second resiliently deflectable detent member (152) is provided on the second lateral boundary (150), **characterized by** a frontplate (180), which is provided on the front (102) of the housing (100) and designed to reduce an escape of electromagnetic radiation from the housing (100) and which is provided with indentations (160, 170),
a first element (144) for actuating the first resiliently deflectable detent member (142) that may be activated from the front (102) of the frontplate (180) and projects into one of the indentations (160) of the frontplate (180),
and a second element (154) for actuating the second resiliently deflectable detent member (152) that may be activated from the front of the frontplate (180) and projects into another indentation (170) of the frontplate (180),
wherein the elements (144, 154; 300) that may be activated are disposed in such a way in the indentations (160, 170) of the frontplate (180) that their joint activation is possible with a single hand.

2. Appliance fan according to claim 1, in which each of the resiliently deflectable detent members (142, 152) has an initial tension that is designed to load the detent member away from the housing (100) in order during insertion of the housing (100) into an appliance (320) to realize a latching of the housing (100) in the appliance (320).

3. Appliance fan according to claim 1 or 2, in which the housing (100) and the elements (144, 154; 300) that may be activated are designed to enable single-handed assembly and/or disassembly of the housing (100) in an appliance (320).

4. Appliance fan according to one of the preceding claims, in which the frontplate (180) has an edge (322), which projects in a direction away from the frontplate towards the housing (100) and in the assembled state is used to form a substantially radiation-proof connection to the appliance (320).

5. Appliance fan according to claim 4, in which the frontplate (180) takes the form of a deep-drawn part, the outline shape of which in the region of the front (102) of the housing (100) forms a plane, with which the edge (322) includes an angle (α).

6. Appliance fan according to claim 5, in which the angle (α) is approximately 90°.

7. Appliance fan according to one of the preceding claims, in which at least one contact element (182, 186) is provided, which in the assembled state connects the frontplate (180) electrically to the housing (100).

8. Appliance fan according to one of the preceding claims, in which extending around the frontplate (180) is at least one EMC sealing element (198), which, when the fan after its assembly in an appliance (320) forms with the latter a gap (330, 334, 338), seals said gap and reduces the escape of electromagnetic radiation from said gap.

9. Appliance fan according to claim 8, in which the EMC sealing element (198) comprises a braid of metallic woven fabric.

10. Appliance fan according to one of the preceding claims, in which the frontplate (180) is constructed from metal.

11. Appliance fan according to one of the preceding claims, in which the frontplate (180) is constructed from metallized plastics material.

12. Appliance fan according to one of the preceding claims, in which the housing (100) comprises at least one fastening element (182, 184, 186, 188) that is designed to fasten the frontplate (180) to the housing (100).

13. Appliance fan according to one of the preceding claims, in which the first detent member (142) has a first initial tension that is designed to move said detent member away from the housing (100),
and the second detent member (152) has a second initial tension that is designed to move said detent member away from the housing (100),
wherein first and second initial tension act substantially in opposite directions (250, 260) in order during insertion of the housing (100) into an appliance (320) to realize a latching by means of the two detent members.

14. Appliance fan according to one of the preceding claims, in which the first and the second element (144, 154) that may be activated are designed upon their activation to move the first and the second detent member (142, 152) out of their latched state in the direction of the housing (100) in order to realize a release of the latching.

15. Appliance fan according to one of the preceding claims, in which a plug-in connector arrangement (200) for the electrical connection is provided at the rear (104) of the housing (100).

16. Appliance fan according to claim 15, in which the plug-in connector arrangement (200) is designed to establish an electrical connection between the appliance fan and an appliance (320) automatically during insertion of the housing (100) into the appliance (320).

17. Appliance fan according to one of the preceding claims, which takes the form of a diagonal fan.

## Revendications

1. Ventilateur d'appareil, muni d'un boîtier (100) réalisé sous la forme d'une pièce insérable destinée à un appareil (320), et présentant un évidement (110) dans lequel se trouvent une roue de ventilateur et un moteur électrique servant à entraîner cette dernière,
de l'air étant acheminé, en service, d'un côté afflux d'air dans le boîtier (100) jusqu'à un côté sortie d'air,
une face antérieure (102) et une face postérieure (104) dudit boîtier (100) s'étendant entre le côté afflux d'air et le côté sortie d'air, ladite face postérieure étant insérée en premier dans l'appareil (320) au stade de l'intégration ou du montage,
et une première délimitation latérale (140) et une seconde délimitation latérale (150) dudit boîtier (100) s'étendant entre le côté afflux d'air et le côté sortie d'air, ainsi qu'entre la face antérieure (102) et la face postérieure (104),
un premier organe d'encliquetage (142), apte à être déployé avec effet de ressort, étant prévu sur la première délimitation latérale (140),
et un second organe d'encliquetage (152), apte à être déployé avec effet de ressort, étant prévu sur la seconde délimitation latérale (150),
**caractérisé par**
un panneau ou écran (180) prévu à la face antérieure (102) du boîtier (100), réalisé pour réduire une sortie de rayonnement électromagnétique hors dudit boîtier (100), et doté de creusures (160, 170),
un premier organe (144) pouvant être activé à partir de la face antérieure (102) de l'écran (180), en vue d'actionner le premier organe d'encliquetage (142) apte à être déployé avec effet de ressort, lequel organe activable (144) pénètre dans l'une (160) des creusures dudit écran (180),
et un second organe (154) pouvant être activé à partir de la face antérieure (102) dudit écran (180), en vue d'actionner le second organe d'encliquetage (152) apte à être déployé avec effet de ressort, lequel organe activable (154) pénètre dans une autre creusure (170) dudit écran (180),
sachant que lesdits organes activables (144, 154 ; 300) sont logés, dans les creusures (160, 170) de l'écran (180), de telle manière que leur activation commune soit possible à l'aide d'une unique main.

2. Ventilateur d'appareil, selon la revendication 1, dans lequel chacun des organes d'encliquetage (142, 152), aptes à être déployé avec effet de ressort, est soumis à une précontrainte réalisée pour éloigner ledit organe d'encliquetage du boîtier (100) en vue de provoquer un enclenchement dudit boîtier (100), dans l'appareil (320), lors de l'insertion dudit boîtier (100) dans ledit appareil (320).

3. Ventilateur d'appareil, selon la revendication 1 ou 2, dans lequel le boîtier (100) et les organes activables (144, 154 ; 300) sont réalisés pour permettre, à l'aide d'une main; un montage et/ou un démontage dudit boîtier (100) dans un appareil (320).

4. Ventilateur d'appareil, selon l'une des revendications précédentes, dans lequel l'écran (180) présente un rebord (322) qui s'éloigne dudit écran en direction du boîtier (100) et sert à établir avec l'appareil (320), à l'état monté, une liaison sensiblement étanche aux rayonnements.

5. Ventilateur d'appareil, selon la revendication 4, dans lequel l'écran (180) est réalisé sous la forme d'une pièce venue d'emboutissage profond dont la configuration du profil matérialise, dans la région de la face antérieure (102) du boîtier (100), un plan avec lequel le rebord (322) décrit un angle (α).

6. Ventilateur d'appareil, selon la revendication 5, dans lequel l'angle (α) mesure environ 90°.

7. Ventilateur d'appareil, selon l'une des revendications précédentes, dans lequel est prévu au moins un élément de contact (182, 186) qui, à l'état monté, raccorde électriquement l'écran (180) au boîtier (100).

8. Ventilateur d'appareil, selon l'une des revendications précédentes, dans lequel est prévu au moins un élément d'étanchement (198) à compatibilité électromagnétique qui s'étend tout autour de l'écran (180) et qui, lorsque ledit ventilateur forme un interstice (330, 334, 338) avec un appareil (320) à l'issue de son montage dans ce dernier, assure l'étanchéité de cet interstice et diminue la sortie d'un rayonnement électromagnétique à partir de cet interstice.

9. Ventilateur d'appareil, selon la revendication 8, dans lequel l'élément d'étanchement (198) à compatibilité électromagnétique présente un tressage de tissu métallique.

10. Ventilateur d'appareil, selon l'une des revendications précédentes, dans lequel l'écran (180) est constitué de métal.

11. Ventilateur d'appareil, selon l'une des revendications précédentes, dans lequel l'écran (180) est constitué d'une matière plastique métallisée.

12. Ventilateur d'appareil, selon l'une des revendications précédentes, dans lequel le boîtier (100) comporte au moins un organe de fixation (182, 184, 186, 188) réalisé pour fixer l'écran (180) audit boîtier (100).

13. Ventilateur d'appareil, selon l'une des revendications précédentes, dans lequel le premier organe d'encliquetage (142) est soumis à une première précontrainte réalisée pour éloigner cet élément d'encliquetage du boîtier (100),
et le second organe d'encliquetage (152) est soumis à une seconde précontrainte réalisée pour éloigner cet organe d'encliquetage dudit boîtier (100),
lesdites première et seconde précontraintes agissant, pour l'essentiel, dans des directions opposées (250, 260) afin de provoquer, lors de l'insertion dudit boîtier (100) dans un appareil (320), un enclenchement assuré par les deux organes d'encliquetage.

14. Ventilateur d'appareil, selon l'une des revendications précédentes, dans lequel les premier et second organes activables (144, 154) sont réalisés, lors de leur activation, pour déplacer les premier et second organes d'encliquetage (142, 152) en direction du boîtier (100), à partir de l'état encliqueté dudit second organe, de manière à provoquer un désenclenchement.

15. Ventilateur d'appareil, selon l'une des revendications précédentes, dans lequel un système d'enfichage (200) est prévu, à la face postérieure (104) du boîtier (100), afin d'assurer la connexion électrique.

16. Ventilateur d'appareil, selon la revendication 15, dans lequel le système d'enfichage (200) est réalisé pour instaurer automatiquement, lors de l'insertion du boîtier (100) dans un appareil (320), une jonction électrique entre ledit ventilateur d'appareil et ledit appareil (320).

17. Ventilateur d'appareil, selon l'une des revendications précédentes, réalisé sous la forme d'un ventilateur diagonal.
